# EUROPÄISCHE PATENTSCHRIFT

(11) **EP 3 794 684 B1**
(45) Veröffentlichungstag und Bekanntmachung des Hinweises auf die Patenterteilung: **24.07.2024**
(21) Anmeldenummer: 19727585.2
(22) Anmeldetag: 10.05.2019
(51) Int. Cl.: H01R 12/70, H01R 12/75, H01R 12/58, H01R 4/20, H01R 13/514

(54) **LEITERKARTENSTECKVERBINDUNG**
PRINTED CIRCUIT BOARD PLUG-IN CONNECTION
CONNECTEUR ENFICHABLE DE CARTE À CIRCUIT IMPRIMÉ

(30) Priorität: 16.05.2018 DE 102018111733
(43) Veröffentlichungstag der Anmeldung: 24.03.2021
(73) Patentinhaber: HARTING Electric Stiftung & Co. KG, 32339 Espelkamp (DE)
(72) Erfinder: KLIEVER, Wilhelm, 32425 Minden (DE)
(86) Internationale Anmeldenummer: PCT/DE2019/100428
(87) Internationale Veröffentlichungsnummer: WO 2019/219125

(56) Entgegenhaltungen:
- EP-A2- 1 041 675
- EP-A2- 1 041 675
- WO-A1-2010/063459
- WO-A1-2010/063459
- WO-A1-2016/184673
- WO-A1-2016/184673
- DE-A1- 102015 119 473
- DE-A1- 102015 204 119
- DE-A1- 102015 204 119
- US-A1- 2006 110 978
- US-A1- 2006 110 978
- US-A1- 2018 109 026
- US-A1- 2018 109 026

## Beschreibung

Die Erfindung geht aus von einer Leiterkartensteckverbindung nach der Gattung des unabhängigen Anspruchs 1.

Derartige Leiterkartensteckverbindungen können einen oder mehrere elektrische Steckkontakte aufweisen und werden benötigt, um ein elektrisches Kabel mit einer Leiterkarte elektrisch zu verbinden und diese Verbindung mit nur geringem Aufwand auch wieder trennen zu können. Insbesondere dient die Leiterkartensteckverbindung dann dazu, Ströme hoher Stromstärken, kurz als "hohe Ströme" bezeichnet, von einem oder mehreren elektrischen Leitern des elektrischen Kabels an eine oder mehrere Leiterbahnen der Leiterkarte zu übertragen. Die Begriffe "hohe Stromstärken" / "hohe Ströme" bedeuten dabei und im Folgenden insbesondere, dass eine solche Steckverbindung pro Steckkontakt einen Strom von z. B. mindestens 10 Ampere, insbesondere mindestens 16 Ampere, beispielsweise mindestens 24 Ampere bevorzugt mindestens 32 Ampere und in einer besonders bevorzugten Ausgestaltung sogar 40 Ampere und mehr übertragen kann.

### Stand der Technik

Im Stand der Technik ist zur Übertragung hoher Ströme von einem Steckverbinder an eine Leiterkarte beispielsweise aus der Druckschrift EP 2 572 405 B1 eine Kontaktfeder für eine Steckverbinderbuchse bekannt. Die Kontaktfeder ist anschlussseitig mit der Leiterkarte verlötbar und kann in einem Isolierkörper angeordnet sein. Steckseitig kann die Kontaktfeder mit einem Gegenkontakt eines Gegensteckers gesteckt werden, dabei wird eine Bauform vorgeschlagen, bei der die Kontaktfeder sowohl mit dem gesteckten Gegenkontakt als auch mit der Leiterkarte eine relativ große gemeinsame Kontaktfläche besitzt. Insbesondere können zwei solche Kontaktfedern an zwei einander gegenüberliegende Kontaktbereiche einer doppelseitig bestückbaren Leiterplatte gelötet und mit einem einzigen Steckvorgang gleichzeitig von zwei Gegenkontakten eines einzigen Gegensteckers kontaktiert werden, um besonders viel Strom zu übertragen.

Nachteilig bei diesem Stand der Technik ist, dass bei der Produktion zunächst die Kontaktfeder im Stanz-Biegeverfahren hergestellt und üblicherweise in dem Isolierkörper angeordnet und, z. B. durch Verrastung, darin gehalten sein muss. Weiterhin ist der in der Regel automatisierte Lötprozess, nämlich der sogenannte "SMT"- (surface mounted technologie)-Prozess, notwendig, um die Kontaktfeder Anschlussseitig auf die Leiterkarte zu löten. Diese Vorgänge sind verhältnismäßig aufwändig, nur teilweise automatisierbar. Daher ist die Herstellung entsprechend teuer.

Die Druckschrift WO 2016/184673 A1 zeigt einen Buchsenkontakt, der als typische Lamellenkontakt ausgeführt ist. Er besitzt eine kabelanschlussseitige Kabelverschraubung und einen Steckberreich mit steckseitigen Kontaktlamellen. Dieser Lamellen-/Buchsenkontakt kann aus einem stangenartigen Rohling durch Bohren und/oder Fräsen einer sich zum distalen Ende hin verjüngenden Kontaktaufnahme und dann durch Einbringen von in Steckrichtung verlaufenden Schlitzen erzeugt werden. Es wird dazu offenbart, in die kegelstumpfartige Kontaktaufnahme im Kontaktbereich scharfkantiger Vertiefungen einzubringen.

Die Druckschrift WO 2010/063459 A1 offenbart einen vibrationsunempfindlichen Leiterkartensteckverbinder für Fahrzeuge, darunter Kraftfahrzeuge und landwirschaftliche Fahrzeuge, Schiffe und Wasserfahrzeuge, Flugzeuge, Zeppeline und Raumschiffe. Dieser Steckverbinder wird im sogenannten "Press In"-Verfahen mit der Leiterkarte verbunden. Dazu wird eine konvexe Form der Außenschenkel seiner Anschlusspins offenbart. Pro Kontaktelement kann er bis zu 25 Ampere und mehr an die Leiterkarte übertragen.

Die Druckschrift DE 10 2015 119 473 A1 offenbart einen Steckkontakt zur elektrischen Kontaktierung einer Leiterplatte mittels Einsteckens des Steckkontakts in ein Kontaktloch der Leiterplatte. Dieser besitzt zwei flache, relativ zueinander federnden Kontaktschenkel und einen Verbindungsbereich, von dem aus sich die beiden Kontaktschenkel in Einsteckrichtung des Steckkontakts erstrecken. Der Steckkontakt ist in einem Stück aus einem metallischen Flachmaterial ausgestanzt. Bei dem erfindungsgemäßen Steckkontakt wird auch bei kleinen Abmessungen eine hohe Kontakt-Normalkraft ermöglicht, so dass der Steckverbinder auch bei Kontaktlöchern mit geringen Durchmesser einen guten und dauerhaften elektrischen Kontakt gewährleistet. Im Verbindungsbereich, angrenzend an die beiden Kontaktschenkel, ist eine Ausnehmung ausgebildet. Die beiden Kontaktschenkel weisen ausgehend von der Ausnehmung einen in Richtung ihrer freien Enden sich vergrößernden Abstand zueinander auf. Die beiden Kontaktschenkel weisen relativ zueinander einen gespreizten Zustand auf. Die beiden Kontaktschenkel weisen zusammen eine Breite auf, die gleich oder nur geringfügig kleiner als der Durchmesserdes korrespondierenden Kontaktlochs in der Leiterplatte ist.

### Aufgabenstellung

Die Aufgabe der Erfindung besteht darin, eine in ihrer Herstellung möglichst unaufwändige und kostengünstige Leiterkartensteckverbindung zur Übertragung möglichst hoher Ströme zwischen einer Leiterkarte und einem elektrischen Kabel anzugeben.

Dabei und im Folgenden bedeutet der Begriff "hohe Ströme", dass die Leiterkartensteckverbindung pro Steckkontakt einen Strom von mindestens 24 Ampere, ("Ampere" wird im Folgenden mit "A" bezeichnet), bevorzugt mindestens 32 A und besonders , bevorzugt sogar 40 A und mehr übertragen kann. Wenn also mehrere, z. B. vier, Steckkontakte zu einer Leiterkartensteckverbindung gehören, dann kann durch die Steckverbindung insgesamt eine entsprechend hohe Stromstärke übertragen werden, also z.B. mindestens 40 A, insbesondere mindestens 64 A, beispielsweise mindestens 96 A, bevorzugt mindestens 128 A und besonders bevorzugt sogar 160 A und mehr. Üblicherweise kann im gesteckten Zustand je ein Steckkontakt der Leiterkartensteckverbindung eine der Adern des elektrischen Kabels mit einer der Leiterbahnen der Leiterkarte elektrisch leitend verbinden.

Diese Aufgabe wird durch die Merkmale des unabhängigen Anspruchs 1.

Eine Leiterkartensteckverbindung besitzt einen Isolierkörper und mindestens einen darin angeordneten Steckkontakt, der als Stiftkontakt mit einer Stiftachse ausgebildet ist. Der mindestens eine Stiftkontakt weist an einem anschlussseitigen Ende einen Kabelanschlussbereich auf. Gegenüberliegend besitzt er ein steckseitiges Ende. Zwischen dem Kabelanschlussbereich und dem steckseitigen Ende weist der Stiftkontakt einen Verbindungsabschnitt auf. Der Stiftkontakt besitzt weiterhin zumindest einen ersten, an dem steckseitigen Ende beginnenden und in Richtung des Kabelanschlussbereichs durch die Stiftachse verlaufenden Schlitz, durch den zumindest zwei in Steckrichtung weisende Segmente des Stiftkontakts gebildet sind.

Dabei ist dem Fachmann klar, dass an den Kabelanschlussbereich das besagte elektrische Kabel anschließbar, d. h. mechanisch daran fixierbar und elektrisch leitend damit verbindbar, ist.

Der Stiftkontakt kann, zumindest bereichsweise, d. h. in einem Bereich des Stiftkontakts, eine Symmetrie aufweisen und kann, zumindest in diesem Bereich, rotationssymmetrisch und/oder spiegelsymmetrisch, insbesondere achsensymmetrisch, ausgeführt sein.

Bevorzugt kann es sich bei der Stiftachse um eine Symmetrieachse des Stiftkontakts oder zumindest eines Abschnitts des Stiftkontakts handeln. Vorteilhafte Ausgestaltungen der Erfindung sind in den Unteransprüchen angegeben.

Ein besonderer Vorteil der Erfindung besteht darin, dass der mindestens eine Stiftkontakt direkt in entsprechende Durchgangskontaktöffnungen der Leiterkarte steckbar und dadurch elektrisch mit dem darin befindlichen Kontaktmaterial der entsprechenden Leiterbahn kontaktierbar ist. Schließlich wird dadurch die Anzahl der Übergangskontakte der Steckverbindung deutlich reduziert.

Da der Leiterkartenverbinder zumindest einen, an dem steckseitigen Ende beginnenden und in Richtung des Kabelanschlussbereichs durch seine Stiftachse verlaufenden Schlitz aufweist, kann er die zur Steckverbindung notwendige Elastizität aufbringen. Insbesondere können seine Segmente sich beim Stecken unter Aufbringung einer entsprechenden Gegenkraft zumindest geringfügig auf einander zu bewegen.

Der Stiftkontakt kann, zumindest bereichsweise, eine Symmetrie aufweisen und kann, zumindest in diesem Bereich, rotationssymmetrisch und/oder spiegelsymmetrisch, insbesondere achsensymmetrisch, ausgeführt sein. Bevorzugt kann es sich bei der Stiftachse um eine Symmetrieachse des Stiftkontakts oder zumindest eines Abschnitts des Stiftkontakts handeln.

Vorteilhafterweise ragt der Stiftkontakt in gestecktem Zustand mit seinem steckseitigen Ende durch eine erste Durchgangskontaktöffnung einer ersten Leiterkarte und kontaktiert dabei einen an - und insbesondere auch in - der Durchgangskontaktöffnung angeordnetem Kontaktmaterial der Leiterkarte elektrisch leitend.

Von besonderem Vorteil ist, dass in dem Stiftkontakt durch den besagten zumindest einen Schlitz in dessen Verbindungs- und im Steckbereich zumindest zwei, insbesondere gleiche, in Steckrichtung freistehende Segmente des Leiterkartenverbinders gebildet sind. Diese zumindest zwei Segmente weisen jeweils in Richtung des steckseitigen Endes und können durch eine zumindest geringfügige elastische Verformung des Leiterkartenverbinders, beispielsweise durch ein Zusammendrücken seines Steckbereichs, mit ihren freistehenden Enden zumindest geringfügig auf einander zu bewegt werden. Durch seinen mindestens einen Schlitz und seine Elastizität, insbesondere sein zumindest geringfügig reversibel verformbares Material, insbesondere Metall, weist der Leiterkartenverbinder schließlich die dafür benötigte zumindest geringfügige Verformbarkeit auf.

Beim Stecken können sich die Segmente mit ihren frei stehenden Enden aufeinander zu bewegen, wobei sich ihre Außenflächen idealerweise parallel zur Steckrichtung ausrichten und unter Aufbringung einer entsprechenden nach außen wirkenden Gegenkraft mit einem in der Durchgangskontaktöffnung der Leiterkarte angeordneten Kontaktmaterial mit einer größtmöglichen gemeinsamen Kontaktfläche idealerweise in paralleler Ausrichtung elektrisch leitend kontaktieren. Das Kontaktmaterial gehört zur entsprechenden Leiterbahn, d. h. es ist zumindest elektrisch leitend mit der jeweiligen Leiterbahn verbunden.

Erfindungsmäßig besitzt der Leiterkartenverbinder zusätzlich einen zweiten, ebenfalls an dem steckseitigen Ende beginnenden und in Richtung des Kabelanschlussbereichs verlaufenden Schlitz, der den ersten Schlitz in der besagten Stiftachse, insbesondere rechtwinklig, kreuzt. Dies ist besonders vorteilhaft, weil sich dadurch die Elastizität des Leiterkartenverbinders erhöht. Schließlich werden dadurch vier, insbesondere gleiche, Segmente des Leiterkartenverbinders gebildet, die unter Aufbringung einer entsprechenden Gegenkraft insbesondere gleichmäßig z. B. in Richtung der Stiftachse zumindest geringfügig elastisch auslenkbar sind. Die Außenflächen der Segmente sind kreissegmentartig ausgeführt, um sich so optimal in die insbesondere kreisrunde Durchgangskontaktöffnung einpassen.

Beim Stecken kann der mindestens eine Stiftkontakt durch eine zumindest geringfügige Verformung des Verbindungsabschnitts unter Aufbringung einer entsprechenden Gegenkraft zumindest geringfügig elastisch komprimiert werden und mit der Gegenkraft gegen den zweiten Kontaktbereich drücken, um diesen mit einem entsprechend hohen elektrischen Leitwert zu kontaktieren.

Insbesondere kann sich der Durchmesser des Verbindungsabschnitts des Stiftkontakts im ungesteckten Zustand zum steckseitigen Ende hin zumindest geringfügig vergrößern. Beispielsweise kann der Verbindungsabschnitt an seinem steckseitigen Ende einen ersten Durchmesser aufweisen, der um mindestens 0,1 mm, bevorzugt mindestens 0,2 mm, insbesondere mindestens 0,3 mm und besonders bevorzugt mindestens 0,4 mm größer ist als ein zweiter Durchmesser, der an zumindest einem anderen Bereich des Verbindungsabschnitts gemessen wird, beispielsweise an demjenigen Bereich, an dem der erste Schlitz endet und/oder z. B. an demjenigen Bereich des Stiftkontakts, der an den Kabelanschlussbereich grenzt.

Von besonderem Vorteil ist es dann weiterhin, wenn die entsprechende Durchgangskontaktöffnung der Leiterkarte einen Durchmesser aufweist, der dem besagten zweiten Durchmesser entspricht. Da die Durchgangskontaktöffnung der Leiterkarte eine zylindrische Form besitzt, ist eine optimale Kontaktfläche mit dem Stiftkontakt schließlich genau dann gegeben, wenn die Außenkonturen der Segmente des Stiftkontakts im gesteckten Zustand zueinander parallel ausgerichtet sind, während sie im ungesteckten Zustand in Steckrichtung leicht nach außen gerichtet sind.

Selbstverständlich kann der Leiterkartenverbinder zusätzlich zu dem ersten und dem zweiten Schlitz noch ein oder mehrere weitere Schlitze besitzen, kann also insgesamt drei, vier, fünf, ..., n derartige Schlitze besitzen, wobei n für eine beliebige natürliche Zahl steht. Diese können eine entsprechende Vielzahl an Segmenten erzeugen. Allerdings ist dabei zu beachten, dass sowohl die Kontaktfläche des Leiterkartenverbinders als auch die Gegenkraft, die er gegen die Verformung aufbringt, mit der Anzahl und/oder Breite der Schlitze abnimmt.

Als besonders vorteilhaft hat sich in der Praxis daher die vorgenannte Variante zweier sich in der Stiftachse rechtwinklig kreuzender Schlitze herausgestellt. Dadurch können im Steck- und im Verbindungsabschnitt des Leiterkartenverbinders vier gleiche Segmente gebildet sein, die sich unter einer gleichmäßigen Belastung gleichmäßig verformen.

In einer weiteren bevorzugten Ausgestaltung endet der Schlitz / enden die Schlitze entweder im Verbindungsabschnitt oder spätestens am Ende des Verbindungsabschnitts. Dies ist besonders vorteilhaft, weil auf diese Weise der Kabelanschlussbereich, der für die Kontaktierung der Leiterkarte vorgesehen ist, massiv ausgebildet ist, da er somit keinen Schlitz aufweist. Schließlich kann er dadurch besonders gut an der ersten Leiterkarte verlötet werden.

Zu seiner besagten elastischen Verformung beim Stecken mit einer Kontaktöffnung, z. B. der Kontaktöffnung einer zweiten Leiterkarte, ist der Stiftkontakt vorteilhafterweise aus einem zumindest geringfügig reversibel verformbaren, elektrisch leitfähigen Material gebildet. Insbesondere kann der Stiftkontakt aus Metall gebildet sein, was diese mechanischen Eigenschaften und zudem die elektrische Leitfähigkeit vorteilhaft begünstigt.

In einer vorteilhaften Ausgestaltung kann es sich bei dem Leiterkartenverbinder in seiner Grundform um ein Drehteil handeln. Dadurch ist er sehr stabil und automatisiert und damit kostengünstig herstellbar. Insbesondere kann der mindestens eine Schlitz mit nur geringem Aufwand, z. B. durch Sägen oder Fräsen, in den Stiftkontakt eingebracht sein.

Der Leiterkartensteckverbinder kann weiterhin die Leiterkarte, oder zumindest die für die Steckverbindung notwendigen Teile der Leiterkarte aufweisen. Zu diesen Teilen gehören können insbesondere die Durchgangskontaktöffnung mit dem darin angeordneten Kontaktmaterial.

Weiterhin kann der Isolierkörper Rastmittel, insbesondere zwei einander gegenüberliegend elastisch daran angeformte Rastarme, besitzen. Die Leiterkarte kann entsprechende Gegenrastmittel, insbesondere Rastöffnungen, besitzen, die von den Rastarmen beim Steckvorgang lösbar verrastend durchgriffen werden. Weiterhin kann die Leiterkarte Positionierungsmittel, insbesondere Positionierungsdurchgangsöffnungen, aufweisen. Der Isolierkörper kann entsprechende, sich an ihren Enden verjüngende Zentrierstifte besitzen, durch die er beim Stecken durch Zusammenwirken mit diesen Positionierungsbohrungen optimal positioniert.

Der Isolierkörper kann in einer bevorzugten Ausgestaltung an zwei einander gegenüberliegenden Seiten mechanische Verbindungsmittel, insbesondere Schwalbenschwanzartige Anformungen, aufweisen. Diese dienen u. a. dem Anfügen weiterer Isolierköper in Form einer Kaskadierung, so dass der Leiterkartensteckverbinder auf diese Weise durch das Anfügen weiterer Isolierkörper beliebig erweiterbar ist.

Weiterhin kann in einer weiteren bevorzugten Ausgestaltung an die mechanischen Verbindungsmittel ein Zugentlastungselement angebracht werden, das gegebenenfalls entsprechende Schwalbenschwanzverbindungen besitzen kann.

An seinem Kabelanschlussbereich kann der Steckkontakt, bei dem es sich insbesondere um den besagten Stiftkontakt handelt, einen Krimpanschluss zum Verbinden mit der entsprechenden Ader des elektrischen Kabels besitzen. Alternativ sind dem Fachmann weitere Anschlussmöglichkeiten bekannt, beispielsweise einen Schraubkontakt oder einen Federkontakt.

### Ausführungsbeispiel

Ein Ausführungsbeispiel der Erfindung ist in den Zeichnungen dargestellt und wird im Folgenden näher erläutert. Es zeigen:
- Fig. 1a - c: einen Stiftkontakt in verschiedenen Ansichten;
- Fig. 2a - d: einen Isolierkörper in verschiedenen Ansichten;
- Fig. 3a - b: den mit den Stiftkontakten bestückten Isolierkörper;
- Fig. 4a - b: eine Leiterkarte;
- Fig. 4c: den auf der Leiterkarte angeordneten Isolierkörper;
- Fig. 5a - b: zwei aneinander befestigte Isolierkörper;
- Fig. 5c: die beiden aneinander befestigten und auf einer weiteren Leiterkarte befestigten Isolierkörper;
- Fig. 6a - c: den Isolierkörper mit einer Zugentlastungseinrichtung.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

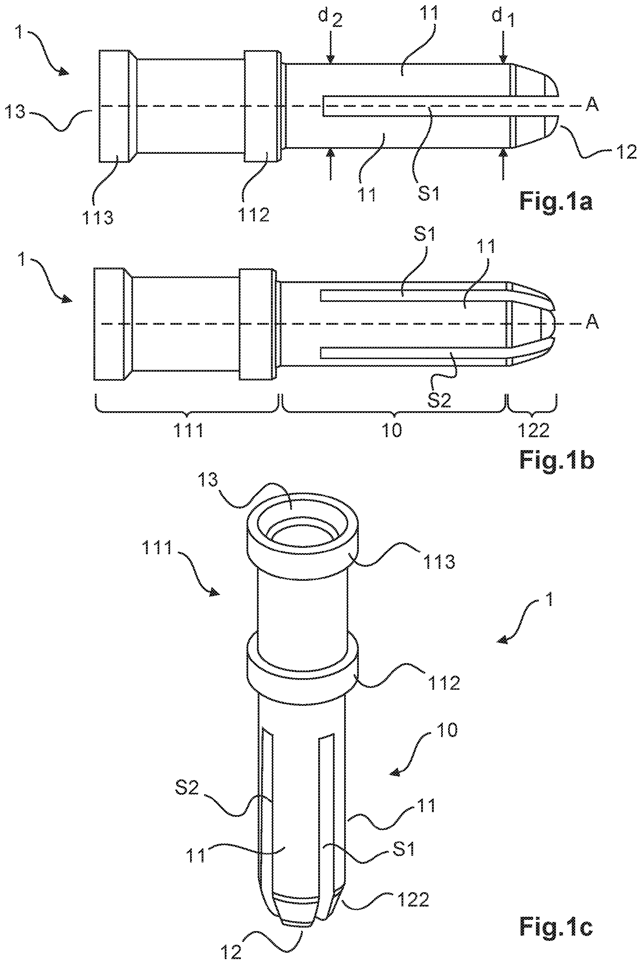

Die Fig. 1a - c zeigen einen Stiftkontakt 1 mit einer als Stiftachse A bezeichneten Symmetrieachse in verschiedenen Ansichten. Der Stiftkontakt 1 besitzt einen Kabelanschlussbereich 111, der als Krimpbereich ausgeführt ist. Der Kabelanschlussbereich 111 ist im Grundzustand, also im nichtverkrimpten Zustand, hohlzylindrisch geformt und besitzt an seinem kabelanschlussseitigen Ende eine Kabeleinführöffnung 13 mit einem Einführkragen 113 zur Aufnahme und elektrischen Kontaktierung einer Ader eines nicht in der Zeichnung dargestellten elektrischen Kabels. An seinem anderen Ende besitzt der Kabelanschlussbereich 111 einen Verbindungskragen 112, über welchen er mit einem Verbindungsabschnitt 10 verbunden ist.

An seinem steckseitigen Ende 12 besitzt der Stiftkontakt 1 einen Verjüngungsabschnitt 122, der über den Verbindungsabschnitt 10 mit dem Kabelanschlussbereich 111 verbunden ist.

Wie aus der Fig. 1a hervorgeht, besitzt der Stiftkontakt 1 zumindest einen ersten, an dem steckseitigen Ende 12 beginnenden und in Richtung des Kabelanschlussbereichs 111 durch die Stiftachse A verlaufenden Schlitz S1, durch den zumindest zwei in Steckrichtung weisende Segmente 11 gebildet sind. Weiterhin besitzt der Stiftkontakt 1 an seinem steckseitigen Ende einen ersten Durchmesser d₁, der um mindestens 0,1 mm größer ist als ein zweiter Durchmesser d₂ welcher an demjenigen Bereich angeordnet ist, an dem der erste Schlitz S1 endet.

Wie in der Fig. 1b dargestellt, besitzt der Stiftkontakt 1 zusätzlich noch einen zweiten Schlitz S2. Dieser beginnt ebenfalls an dem steckseitigen Ende 12 und verläuft in Richtung des Kabelanschlussbereichs 111, wobei er der den ersten Schlitz S1 in der Stiftachse A rechtwinklig kreuzt. Durch diese beiden Schlitze S1, S2 sind vier gleiche, in Steckrichtung weisende Segmente 11 gebildet.

Die Fig. 1c zeigt den Stiftkontakt 1 in einer 3D-Darstellung. Dabei ist insbesondere die Kabeleinführöffnung 13 des Kabelanschlussbereichs/ Crimpbereichs 111 besonders gut zu sehen. Weiterhin wird besonders gut deutlich, wie durch die beiden Schlitze S1, S2 die Segmente 11 gebildet sind.

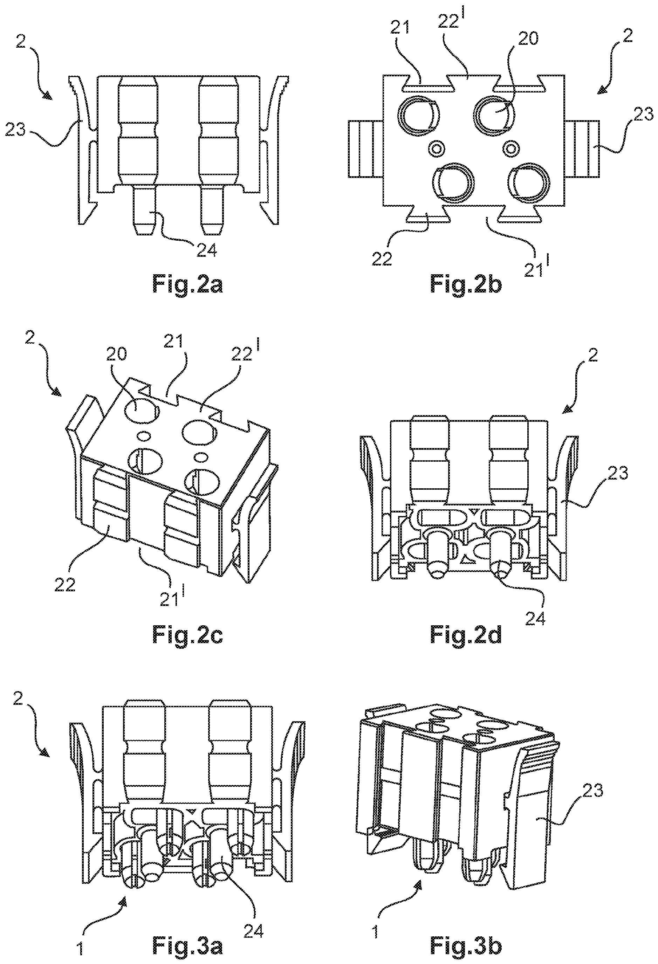

Die Fig. 2a - d zeigen einen Isolierkörper 2 in verschiedenen Ansichten. In der Fig. 2a ist der Isolierkörper in einer Seitenansicht gezeigt. Er besitzt an zwei einander gegenüberliegenden Schmalseiten je einen Rastarm 23 sowie an einer Leiterkartenanschlussseite zwei Zentrierstifte 24.

In der Fig. 2b sind die Kontaktaufnahmen 20 besonders gut zu sehen. Diese sind als Durchgangsöffnungen ausgeführt, in welche die Stiftkontakte 1 einführbar und in denen sie verratsbar sind.

Weiterhin besitzt der Isolierkörper an zwei einander gegenüberliegenden Längsseiten je eine Befestigungsvorrichtung in Form einer Schwalbenschwanzverbindung mit je zumindest einem Zapfen 22, 22' und je einer entsprechenden Ausnehmung 21, 21'.

Die Fig. 2c zeigt den Isolierkörper in einer schrägen Draufsicht auf die Kabelanschlussseite. Die Fig. 2d zeigt den Isolierkörper 2 mit Blick auf die Steckseite.

Die Fig. 3a und 3b zeigen den Isolierkörper 2 mit den in den Kontaktaufnahmen 20 aufgenommenen Stiftkontakten 1.

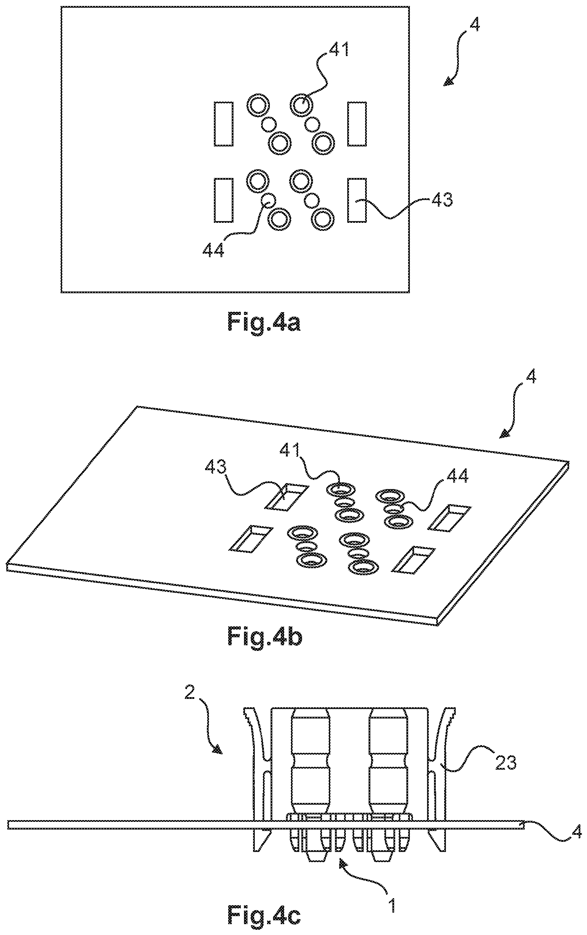

Die Fig. 4a und 4b zeigen eine Leiterkarte 4 in einer Draufsicht und in einer schrägen Draufsicht. Diese Leiterkarte 4 besitzt Rastöffnungen 43, die dazu geeignet sind, von den Rastarmen 23 des Isolierkörpers 2 lösbar verrastend durchgriffen zu werden. Weiterhin besitzt die Leiterkarte 4 Durchgangskontaktöffnungen 41 mit darin angeordnetem Kontaktmaterial zum Einstecken und elektrischen Kontaktieren der Stiftkontakte 1. Das Kontaktmaterial ist elektrisch leitend mit nicht dargestellten Leiterbahnen der Leiterkarte 4 verbunden. Weiterhin besitzt die Leiterkarte 4 Positionierungsdurchgangsöffnungen 44.

Die Fig. 4c zeigt die Leiterkarte 4 mit dem daran lösbar verrasteten Isolierkörper 2 und den darin angeordneten und in die Durchgangkontaktöffnungen 41 gesteckten Stiftkontakten 1.

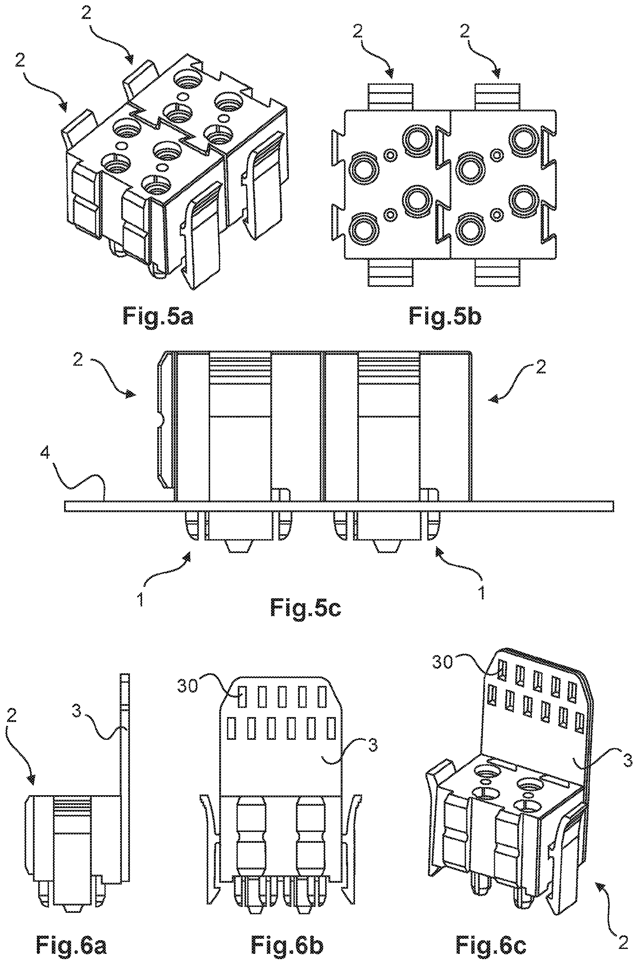

In den Fig. 5a und 5b sind zwei mit ihren Befestigungsvorrichtungen aneinander befestigte Isolierkörper 2 gezeigt.

Die Fig. 5c zeigt die beiden aneinander befestigten Isolierkörper 2, die gemeinsam an der Leiterkarte 4 verrastet sind, wobei die in den Isolierköpern aufgenommenen Stiftkontakte 1 in die Durchgangskontaktöffnungen 41 gesteckt sind und dabei elektrisch mit dem darin angeordneten Kontaktmaterial kontaktieren. Beim Steckvorgang wird die Positionierung der Isolierkörper 2 und damit auch die Positionierung der Stiftkontakte 1 durch ein Zusammenwirken der Zentrierstifte 24 mit den Positionierungsdurchgangsöffnungen 44 der Leiterkarte 4.

In den Fig. 6a - c ist ein Zugentlastungselement 3 in Verbindung mit dem Isolierkörper 2 dargestellt. Das Zugentlastungselement 3 besitzt ebenfalls eine Befestigungsvorrichtung, die mit der Befestigungseinrichtung der Isolierkörper korrespondiert. Weiterhin besitzt das Zugentlastungselement 3 Befestigungsöffnungen 30, an denen Adern des nicht gezeigten Kabels z. B. mit Kabelbindern befestigbar sind.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Stiftkontakt
- 10: Verbindungsabschnitt
- 11: Segmente
- 111: Kabelanschlussbereich
- 12: steckseitiges Ende
- 13: Kabeleinführöffnung
- 112: Verbindungskragen
- 113: Einführkragen
- 122: Verjüngungsabschnitt
- A: Stiftachse
- d₁, d₂: Durchmesser des Stiftkontakts
- S1, S2: erster, zweiter Schlitz
- 2: Isolierkörper
- 20: Kontaktaufnahmen
- 21, 21': Ausnehmung
- 22, 22': Zapfen
- 23: Rastarme
- 24: Zentrierstifte
- 3: Zugentlastungselement
- 30: Befestigungsöffnungen
- 4: Leiterkarte
- 41: Durchgangskontaktöffnungen
- 43: Rastöffnungen
- 44: Positionierungsdurchgangsöffnungen

## Patentansprüche

1. Leiterkartensteckverbindung zur Verbindung eines elektrischen Kabels mit einer Leiterkarte (4), aufweisend mindestens einen Isolierkörper (2) und mindestens einen darin angeordneten Stiftkontakt (1), der eine Stiftachse (A) besitzt und an einem anschlussseitigen Ende einen Kabelanschlussbereich (111) aufweist und gegenüberliegend ein steckseitiges Ende (12) besitzt, um damit im gesteckten Zustand durch eine Durchgangskontaktöffnung (41) der Leiterkarte (4) zu ragen und dabei mit darin angeordnetem Kontaktmaterial einer Leiterbahn der Leiterkarte elektrisch leitend kontaktieren, wobei der Stiftkontakt (1) zwischen dem Kabelanschlussbereich (111) und dem steckseitigen Ende (12) einen Verbindungsabschnitt (10) aufweist, wobei der Stiftkontakt (1) zumindest einen ersten, an dem steckseitigen Ende (12) beginnenden und in Richtung des Kabelanschlussbereichs (111) durch die Stiftachse (A) verlaufenden Schlitz (S1) aufweist, durch den zumindest zwei in Steckrichtung weisende Segmente (11) des Stiftkontakts (1) gebildet sind, **dadurch gekennzeichnet, dass** die Segmente (11) Außenkonturen besitzen, die im ungesteckten Zustand in Steckrichtung leicht nach außen gerichtet und im gesteckten Zustand unter Aufbringung einer Gegenkraft parallel zueinander ausgerichtet sind, um die Kontaktierung mit dem Kontaktmaterial der besagten Leiterbahn an einer größtmöglichen gemeinsamen Kontaktfläche zu ermöglichen und so dazu eingerichtet ist, pro Stiftkontakt (1) hohe Ströme von mindestens 24 A ("Ampere") vom elektrischen Kabel an die Leiterkarte (4) zu übertragen, wobei der Stiftkontakt (1) zusätzlich einen zweiten, ebenfalls an dem steckseitigen Ende (12) beginnenden und in Richtung des Kabelanschlussbereichs (111) verlaufenden Schlitz (S2) besitzt, der den ersten Schlitz (S1) in der Stiftachse (A) kreuzt, wodurch vier in Steckrichtung weisende Segmente (11) gebildet sind, die kreissegmentartig ausgeführte Außenflächen aufweisen, um sich optimal in die kreisrunde Durchgangskontaktöffnung (41) einzupassen.

2. Leiterkartensteckverbindung nach Anspruch 1, wobei der erste (S1) und der zweite Schlitz (S2) sich in der Stiftachse (A) rechtwinklig kreuzen.

3. Leiterkartensteckverbindung nach einem der vorstehenden Ansprüche, wobei die Schlitze (S1, S2) entweder im Verbindungsabschnitt (10) oder spätestens am Ende des Verbindungsabschnitts (10) enden.

4. Leiterkartensteckverbindung nach einem der vorstehenden Ansprüche, wobei der Stiftkontakt (1) aus einem zumindest geringfügig elastisch verformbaren, elektrisch leitfähigen Material gebildet ist.

5. Leiterkartensteckverbindung nach einem der vorstehenden Ansprüche, wobei der Stiftkontakt (1) aus Metall gebildet ist.

6. Leiterkartensteckverbindüng nach einem der.vorstehenden Ansprüche, wobei es sich bei dem Stiftkontakt (1) um ein Drehteil handelt.

7. Leiterkartensteckverbindung nach einem der vorstehenden Ansprüche, wobei der Schlitz (S1) oder die Schlitze (S1, S2) durch Sägen oder Fräsen in den Stiftkontakt (1) eingebracht sind.

8. Leiterkartensteckverbindung nach einem der vorstehenden Ansprüche, wobei der Stiftkontakt (1) zumindest abschnittsweise symmetrisch geformt ist, und dass es sich bei der Stiftachse (A) zumindest bereichsweise um eine Symmetrieachse des Stiftkontakts (1) handelt.

9. Leiterkartensteckverbindung nach einem der vorstehenden Ansprüche, wobei sich der Durchmesser (d₁, d₂) des Verbindungsabschnitts (10) im ungesteckten Zustand zum steckseitigen Ende (12) hin zumindest geringfügig vergrößert.

10. Leiterkartensteckverbindung nach einem der vorstehenden Ansprüche, wobei die Steckverbindung mehrere Isolierkörper (2) aufweist, welche je eine Befestigungsvorrichtung zur gegenseitigen mechanischen Befestigung besitzen.

11. Leiterkartensteckverbindung nach Anspruch 10, wobei jeder der Isolierkörper (2) an zwei einander gegenüberliegende Seiten als Befestigungsvorrichtung schwalbenschwanzförmige Zapfen (22, 22') und Ausnehmungen (21, 21') aufweist.

12. Leiterkartensteckverbindung nach Anspruch 11, wobei die mehreren Isolierkörper (2) aneinander angeordnet und befestigt sind und an der Befestigungsvorrichtung einer frei stehenden Seite eines Isolierkörpers (2), der sich an einem Ende dieser Anordnung befindet, ein Zugentlastungselement (3) zur Zugentlastung einzelner Adern des elektrischen Kabels angebracht ist.

13. Leiterkartensteckverbindung nach einem der vorstehenden Ansprüche, wobei jeder Isolierkörper (2) Rastarme (23) zur Verrastung an der Leiterkarte (4) aufweist.

14. System aus einer Leiterkartensteckverbindung nach Anspruch 13 und einer Leiterkarte (4), welche die folgenden Elemente aufweist:
- Rastöffnungen (43), zum Verrasten der Rastarme (23) des Isolierkörpers (2);
- Positionierungsdurchgangsöffnungen (44);
- Zumindest eine Durchgangskontaktöffnung (41) mit darin angeordnetem Kontaktmaterial.

## Claims

1. Printed circuit board plug-in connection for connecting an electric cable to a printed circuit board (4), having at least one insulating body (2) and at least one pin contact (1) which is arranged in said insulating body, has a pin axis (A) and has a cable connection region (111) at a connection-side end and, opposite to this, has a plug-in end (12) in order to protrude through a first passage contact opening (41) of the printed circuit board (4) by way of said plug-in end in the plugged-in state and in so doing make electrically conductive contact with a contact material of a conductor track of the printed circuit board that is arranged in said passage contact opening, wherein the pin contact (1) has a connecting section (10) between the cable connection region (111) and the plug-in end (12), wherein the pin contact (1) has at least one first slot (S1) which starts at the plug-in end (12) and runs through the pin axis (A) in the direction of the cable connection region (111), at least two segments (11) of the pin contact (1) that point in the plug-in direction being formed by said slot, **characterized in that** the segments (11) have outer contours which are oriented slightly outward in the plug-in direction in the non-plugged-in state and are oriented parallel to one another in the plugged-in state with application of a counterforce in order to allow contact to be made with the contact material of said conductor track over a common contact area which is as large as possible, and therefore is designed to transmit high currents of at least 24 A ("amperes") from the electric cable to the printed circuit board (4) for each pin contact (1), wherein the pin contact (1) additionally has a second slot (S2) which likewise starts at the plug-in end (12) and runs in the direction of the cable connection region (111), which second slot intersects the first slot (S1) in the pin axis (A), as a result of which four segments (11) which point in the plug-in direction are formed, the segments having outer surfaces designed in the form of a segment of a circle in order to fit in an optimum manner into the round passage contact opening (41).

2. Printed circuit board plug-in connection according to Claim 1, wherein the first slot (S1) and the second slot (S2) intersect at a right angle in the pin axis (A).

3. Printed circuit board plug-in connection according to either of the preceding claims, wherein the slots (S1, S2) end either in the connecting section (10) or at the latest at the end of the connecting section (10).

4. Printed circuit board plug-in connection according to one of the preceding claims, wherein the pin contact (1) is formed from an at least slightly elastically deformable, electrically conductive material.

5. Printed circuit board plug-in connection according to one of the preceding claims, wherein the pin contact (1) is formed from metal.

6. Printed circuit board plug-in connection according to one of the preceding claims, wherein the pin contact (1) is a rotary part.

7. Printed circuit board plug-in connection according to one of the preceding claims, wherein the slot (S1) or the slots (S1, S2) is/are made in the pin contact (1) by sawing or milling.

8. Printed circuit board plug-in connection according to one of the preceding claims, wherein the pin contact (1) is symmetrically formed at least in sections, and that the pin axis (A) is an axis of symmetry of the pin contact (1) at least in regions.

9. Printed circuit board plug-in connection according to one of the preceding claims, wherein the diameter (d₁, d₂) of the connecting section (10) is at least slightly increased in size in the direction of the plug-in end (12) in the non-plugged-in state.

10. Printed circuit board plug-in connection according to one of the preceding claims, wherein the plug-in connection has a plurality of insulating bodies (2) which each have a fastening, apparatus for mutual mechanical fastening.

11. Printed circuit board plug-in connection according to Claim 10, wherein each of the insulating bodies (2) has dovetail-like pegs (22, 22') and recesses (21, 21') as the fastening apparatus on two sides which are situated opposite one another.

12. Printed circuit board plug-in connection according to Claim 11, wherein the plurality of insulating bodies (2) are arranged and fastened one on the other and a strain-relief element (3) is fitted to the fastening apparatus of a free-standing side of an insulating body (2), which is located at one end of this arrangement, in order to provide strain relief for individual cores of the electric cable.

13. Printed circuit board plug-in connection according to one of the preceding claims, wherein each insulating body (2) has latching arms (23) for latching to the printed circuit board (4).

14. System comprising a printed circuit board plug-in connection according to Claim 13 and a printed circuit board (4) which has the following elements:
- latching openings (43) for latching the latching arms (23) of the insulating body (2);
- positioning passage openings (44);
- at least one passage contact opening (41) with contact material arranged in said passage contact opening.

## Revendications

1. Connecteur de carte de circuit imprimé enfichable destiné à relier un câble électrique à une carte de circuit imprimé (4), ledit connecteur comportant au moins un corps isolant (2) et au moins un contact à broche (1) qui est disposé à l'intérieur de celui-ci, qui possède un axe de broche (A) et qui comporte une zone de raccordement de câble (111) à une extrémité côté raccordement et qui possède une extrémité côté enfichage (12) du côté opposé afin de faire saillie par une ouverture de contact traversante (41) de la carte de circuit imprimé (4) à l'état enfiché et ainsi réaliser un contact électriquement conducteur avec une matière de contact, disposée à l'intérieur, d'une piste conductrice de la carte de circuit imprimé,
le contact à broche (1) comportant une portion de connexion (10) entre la zone de raccordement de câble (111) et l'extrémité côté enfichage (12), le contact à broche (1) comportant au moins une première fente (S1) qui commence à l'extrémité côté enfichage (12) et qui s'étend en direction de la zone de raccordement de câble (111) par le biais de l'axe de broche (A) et à travers laquelle sont formés au moins deux segments (11), orientés dans le sens d'enfichage, du contact à broche (1), **caractérisé en ce que**
les segments (11) possèdent des contours extérieurs qui, à l'état non enfiché, sont légèrement dirigés vers l'extérieur dans la direction d'enfichage et, à l'état enfiché, sont orientés parallèlement les uns aux autres sous l'application d'une force antagoniste pour permettre le contact avec la matière de contact de ladite piste conductrice sur la plus grande surface de contact commune possible et est ainsi conçu pour transmettre des courants élevés d'au moins 24 A (« ampères ») du câble électrique à la carte de circuit imprimé (4) par contact à broche (1),
le contact à broche (1) possédant en outre une deuxième fente (S2) qui commence également à l'extrémité côté enfichage (12) et qui s'étend en direction de la zone de raccordement de câble (111) et qui croise la première fente (S1) dans l'axe de broche (A), ce qui forme quatre segments (11) orientés dans la direction d'enfichage qui comportent des surfaces extérieures conçues comme un segment de cercle pour s'adapter de manière optimale dans l'ouverture de contact traversante circulaire (41).

2. Connecteur de carte de circuit imprimé enfichable selon la revendication 1, la première fente (S1) et la deuxième fente (S2) se croisant à angle droit dans l'axe de broche (A).

3. Connecteur de carte de circuit imprimé enfichable selon l'une des revendications précédentes, les fentes (S1, S2) se terminant soit dans la portion de connexion (10), soit au plus tard à l'extrémité de la portion de connexion (10).

4. Connecteur de carte de circuit imprimé enfichable selon l'une des revendications précédentes, le contact à broche (1) étant formé à partir d'une matière électriquement conductrice au moins légèrement déformable élastiquement.

5. Connecteur de carte de circuit imprimé selon l'une des revendications précédentes, le contact à broche (1) étant formé à partir d'un métal.

6. Connecteur de carte de circuit imprimé selon l'une des revendications précédentes, le contact à broche (1) étant une pièce rotative.

7. Connecteur de carte de circuit imprimé selon l'une des revendications précédentes, la fente (S1) ou les fentes (S1, S2) étant réalisées dans le contact à broche (1) par sciage ou fraisage.

8. Connecteur de carte de circuit imprimé enfichable selon l'une des revendications précédentes, le contact à broche (1) étant formé au moins par portions de manière symétrique, et l'axe de broche (A) étant au moins par zones un axe de symétrie du contact à broche (1).

9. Connecteur de carte de circuit imprimé enfichable selon l'une des revendications précédentes, le diamètre (d₁, d₂) de la portion de connexion (10) augmentant au moins légèrement en direction de l'extrémité côté enfichage (12) à l'état non enfiché.

10. Connecteur de carte de circuit imprimé enfichable selon l'une des revendications précédentes, le connecteur enfichable comportant plusieurs corps isolants (2), qui comportent chacun un dispositif de fixation destiné à une fixation mécanique mutuelle.

11. Connecteur de carte de circuit imprimé enfichable selon la revendication 10, chacun des corps isolants (2) comportant sur deux côtés opposés des tenons (22, 22') et des évidements (21, 21') en forme de queue d'aronde qui servent de dispositif de fixation.

12. Connecteur de carte de circuit imprimé enfichable selon la revendication 11, les plusieurs corps isolants (2) étant disposés et fixés les uns aux autres et un élément de décharge de traction (3) destiné à soulager la traction de fils individuels du câble électrique étant fixé au dispositif de fixation d'un côté libre d'un corps isolant (2) qui est situé à une extrémité de cet ensemble.

13. Connecteur de carte de circuit imprimé enfichable selon l'une des revendications précédentes, chaque corps isolant (2) comportant des bras d'encliquetage (23) destinés à s'encliqueter sur la carte de circuit, imprimé (4).

14. Système comprenant un connecteur de carte à circuit enfichable selon la revendication 13 et une carte de circuit imprimé (4) qui comporte les éléments suivants :
- des ouvertures d'encliquetage (43) destinées à l'encliquetage des bras d'encliquetage (23) du corps isolant (2) ;
- des ouvertures de positionnement traversantes (44) ;
- au moins une ouverture de contact traversante (41) dans laquelle est disposée une matière de contact.
